(19) Europäisches Patentamt
European Patent Office
Office européen des brevets

(11) **EP 2 869 552 A1**

(12) **EUROPEAN PATENT APPLICATION**

(43) Date of publication:
**06.05.2015 Bulletin 2015/19**

(51) Int Cl.:
**H04N 5/345** (2011.01)  **H04N 5/372** (2011.01)

(21) Application number: **14188115.1**

(22) Date of filing: **08.10.2014**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **05.11.2013 JP 2013229582**

(71) Applicant: **Olympus Corporation Tokyo 151-0072 (JP)**

(72) Inventor: **Fujiki, Hiroshi Tokyo, 151-0072 (JP)**

(74) Representative: **Gunzelmann, Rainer Wuesthoff & Wuesthoff Patentanwälte PartG mbB Schweigerstraße 2 81541 München (DE)**

(54) **Imaging apparatus having an imaging element with plural readout means each for reading out a partial image region**

(57)     An imaging apparatus capable of outputting high-quality images at high frame rate by partial readout while suppressing a difference among output signals from the output units is provided. The apparatus includes: an imaging element 11 including an effective pixel region having a plurality of adjacent unit regions each including a plurality of pixels for converting a subject image into imaging signals, and a plurality of output units, one for the each of the unit regions; a region-of interest setting unit 25 setting a region of interest for the subject image; a readout-region setting unit 26 setting a region including the region of interest and axisymmetric about a boundary between the unit regions as a readout region; and a drive control unit 18 driving the imaging element to read out imaging signals of the pixels included in the readout region, and to sweep out those in the other regions.

FIG. 9

**Description**

{Technical Field}

The present invention relates to an imaging apparatus, more particularly, an imaging apparatus including an imaging element that outputs imaging signals, which are obtained from light-receiving elements, simultaneously from a plurality of output units and that reads out imaging data at high speed.

{Background Art}

In accordance with an increase in the number of pixels and an increase in the frame rate of digital cameras or the like, there is proposed an imaging element in which an imaging element is divided into a plurality of vertical or horizontal regions, output units are provided for the respective divided regions, and imaging data is read out from each output unit for each region in parallel, thereby increasing the readout rate of the imaging data.

In such an imaging element provided with a plurality of output units, because of the difference in characteristics among the output units, imaging data may differ among the output units even if the imaging data is acquired under the same imaging conditions, which may possibly result in a conspicuous difference in a level among the output units on the resultant image. Therefore, to solve such a problem, PTL 1 for example, discloses a technique for providing a correction circuit in rear of an amplifier circuit which is an output unit and correcting the difference among the output units using the correction circuit.

Meanwhile, there is a need in the field of physiology for observing the moving state of a sample, the reaction of a sample when the sample is optically or electrically stimulated, or the like using a microscopic imaging apparatus, and for tracking the high-speed temporal change of the sample when the image is recorded. To meet such a need, there is proposed an imaging apparatus which has a partial readout function capable of reading out electrical charge generated through photoelectric conversion in the imaging element for pixels of only part of a region instead of reading out electrical charge for pixels over the entire regions of the light-receiving surface, so that a higher frame rate is realized. This partial readout function is also referred to as partial scan subarray readout, ROI (Region Of Interest) readout, or the like.

For example, PTL 2 discloses a technique for partially reading out data from an imaging element that performs high-speed sweep-out. That is, in PTL 2, during normal readout, when transfer of the electrical charge corresponding to one line in a horizontal direction of the imaging element is finished, the imaging element is shifted by one line in a vertical direction. On the other hand, during high-speed sweep-out, when transfer of electrical charge corresponding to one line in the horizontal direction is finished, the imaging element is shifted by a plurality of lines and the electrical charge corresponding to the plurality of lines is mixed and swept out together. Furthermore, for example, if a region of interest (ROI) is to be partially read out, normal readout is performed in the ROI while high-speed sweep-out is performed in regions other than the ROI. Therefore, it is possible to increase the frame rate by shortening readout time for the regions other than the ROI.

{Citation List}

{Patent Literature}

{PTL 1}
Japanese Unexamined Patent Application, Publication No. 2004-146897
{PTL 2}
Japanese Unexamined Patent Application, Publication No. 2004-104561

{Summary of Invention}

{Technical Problem}

However, when partial readout as described above is performed, the following problems may occur. If the ROI to be read out is located at a position shifted toward the pixels corresponding to a particular output unit, a difference occurs among readout patterns from the output units. That is, depending on the position of the ROI, there is a case where a difference in the amount of data subjected to the high-speed sweep-out occurs among the output units. For example, some output units have fewer pixels to be subjected to the high-speed sweep-out while the other output units have more pixels subjected to the high-speed sweep-out. These different readout patterns make the temperature distribution of the imaging element non-uniform because of the difference in the amount of heat generation among the output units. This non-uniform temperature distribution may, in turn, cause a temperature difference among the output units and eventually a difference among output signals.

The present invention has been made in view of the above-described circumstances, and an object of the present invention is to output high-quality images at high frame rate by performing partial readout while suppressing a difference among output signals from a plurality of output units of an imaging element that includes the output units.

{Solution to Problem}

To achieve the above-described object, the present invention provides the following solution.

According to one aspect of the present invention, there is provided an imaging apparatus including: an imaging element including an effective pixel region in which a plurality of unit regions are adjacent to one another, the unit regions each including a plurality of pixels for converting a subject image into imaging signals; and a plurality of output units provided for the respective unit regions, the output units outputting the imaging signal obtained by conversion at the pixels included in the respective unit regions; a region-of-interest setting unit that sets a region of interest for the subject image; a readout-region setting unit that sets a region including the region of interest and axisymmetric with respect to a boundary between the unit regions as a readout region in the effective pixel region; and a drive control unit that drives the imaging element to read out imaging signals of the pixels included in the readout region, and to sweep out imaging signals of pixels other than the pixels included in the read out region.

According to this aspect, in the imaging apparatus which images a subject image using an imaging element having a plurality of unit regions and output units provided for the respective unit regions, if a region of interest of the subject image is partially read out and the region of interest to be read out is set, the readout-region setting unit sets the readout region axisymmetric with respect to the boundary between the unit regions so as to include the region of interest. The drive control unit drives the imaging element to read out imaging signals of the pixels included in the readout region, and to sweep out imaging signals of the pixels other than the pixels included in the readout region.

With this configuration, if the region of interest is partially read out, it is possible to increase a frame rate. since the imaging element is driven so as to read out only imaging signals of the pixels included in the readout region in the effective pixel region without reading out the entire effective pixel regions, and to sweep out the imaging signals of the pixels in other regions. Furthermore, the difference in the imaging signals output from the output units to which the unit regions belong rarely occurs since the readout region is axisymmetric with respect to the boundary between the unit regions. That is, the amount of heat generation is substantially the same among the output units since the signal patterns of the read imaging signals are substantially the same as those of the swept imaging signals for the pixels included in each unit region,. It is, therefore, possible to perform partial readout while suppressing the difference among imaging signals which are the output signals from the output units, and to output high-quality images at high frame rate.

In the above-described aspect, it is preferable that the unit regions are obtained by dividing the effective pixel region in a horizontal direction, and the output units are provided for the respective unit regions.

With this configuration, if the imaged image is partially read out using the imaging element including the effective pixel region having the unit regions divided in the horizontal direction, it is possible to output high-quality images at high frame rate by performing partial readout while suppressing the difference among the imaging signals which are output signals from the output units.

In the above-described aspect, it is preferable that the unit regions are obtained by dividing the effective pixel region in a vertical direction and the output units are provided for the respective unit regions.

With this configuration, if the imaged image is partially read out using the imaging element including the effective pixel region having the unit regions divided in the vertical direction, it is possible to output high-quality images at high frame rate by performing partial readout while suppressing the difference among the imaging signals which are output signals from the output units.

In the above-described aspect, it is preferable that the region-of-interest setting unit holds in advance a plurality of regions which are axisymmetric with respect to the boundary between the unit regions as region-of-interest candidates, and sets any one of the region-of-interest candidates as the region of interest.

With this configuration, the region-of-interest setting unit holds in advance the plurality of regions as region-of-interest candidates. Owing to this, a user can set the region of interest only by performing simple operation of selecting any one region which includes a desired region as the region of interest. Furthermore, the region of interest itself is axisymmetric with respect to the boundary of the unit regions. Owing to this, it is possible to set the set region of interest as it is or set a region extending in a direction in which the region of interest is axisymmetric as the readout region, to output high-quality images at high frame rate by performing partial readout while reducing the amount of operation and suppressing the difference among the imaging signals which are output signals from the output units.

{Advantageous Effects of Invention}

According to the present invention, it is advantageously possible to output high-quality images at high frame rate by performing partial readout while suppressing the difference among the output signals from a plurality of output units of the imaging element that includes the output units.

{Brief Description of Drawings}

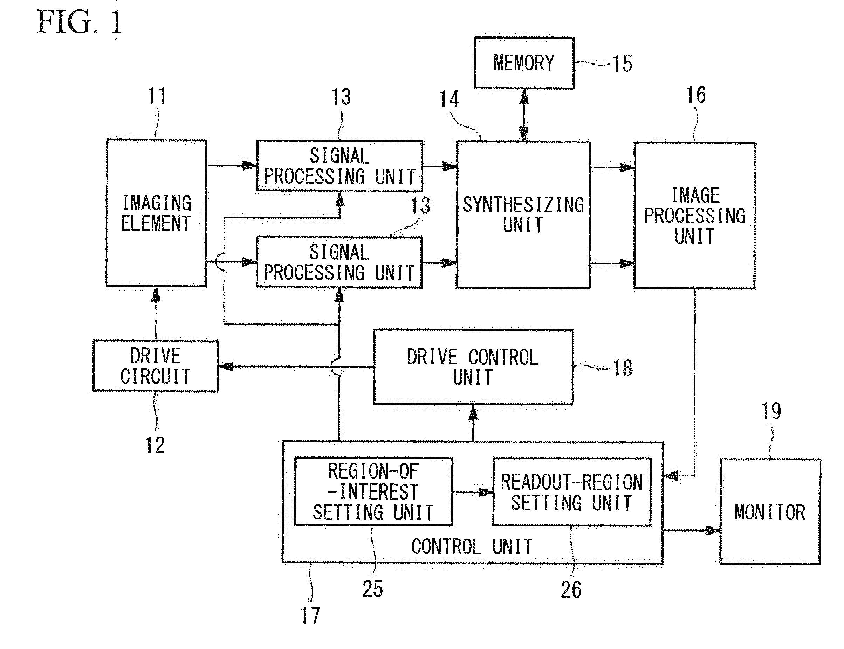

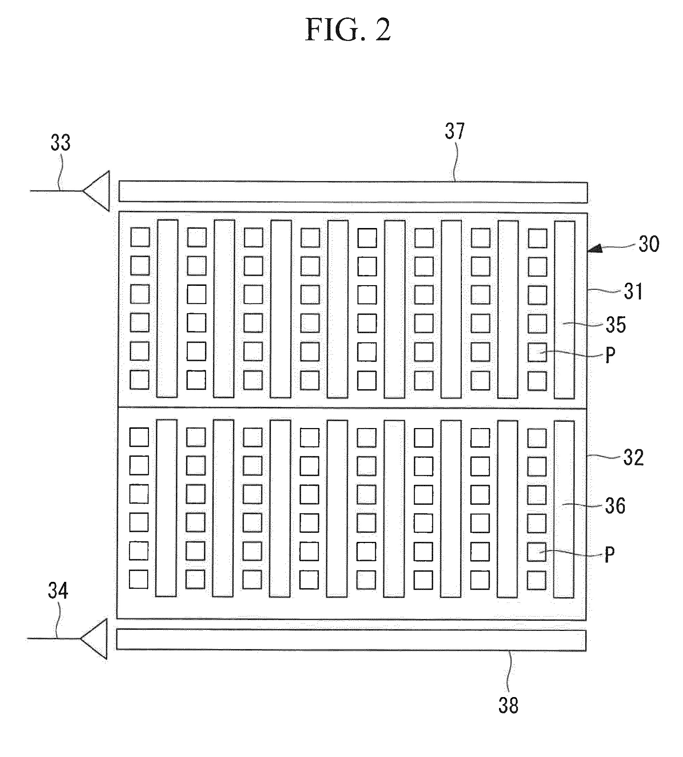

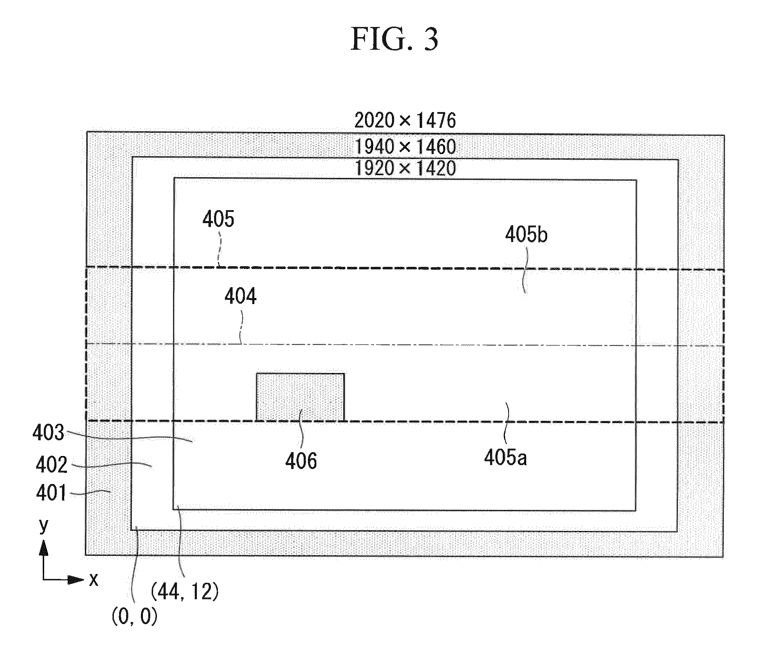

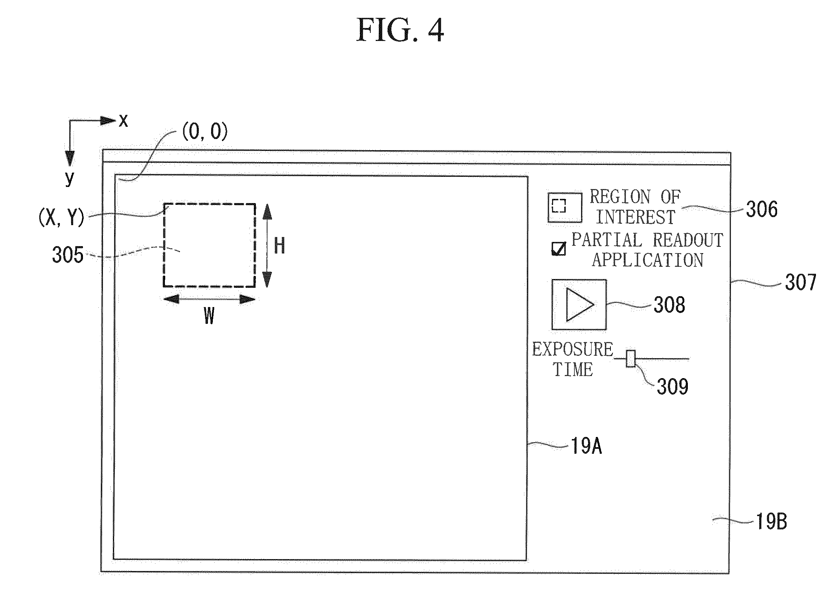

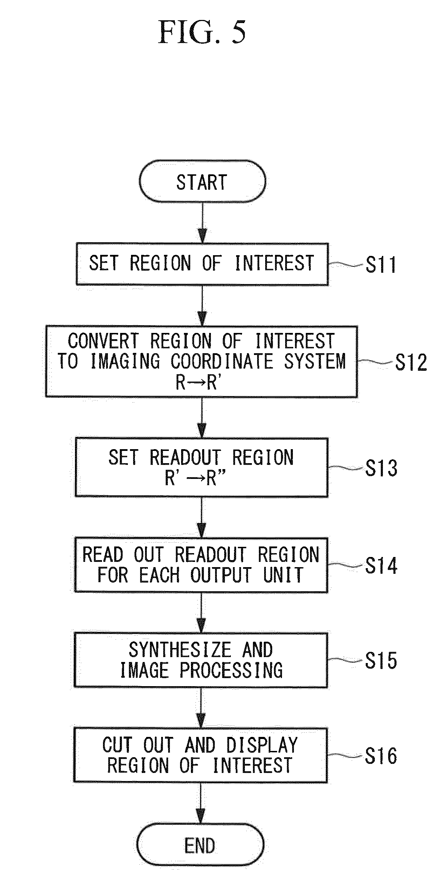

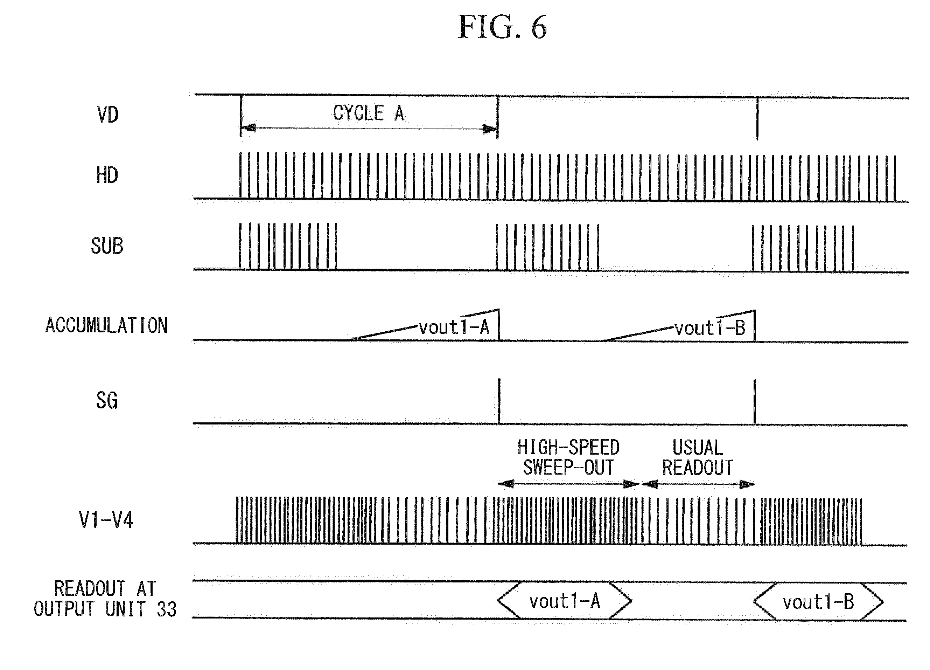

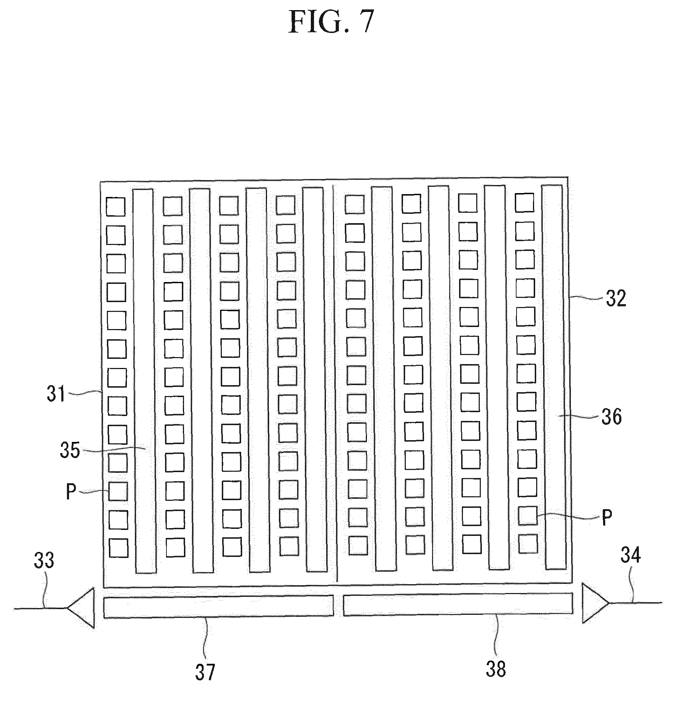

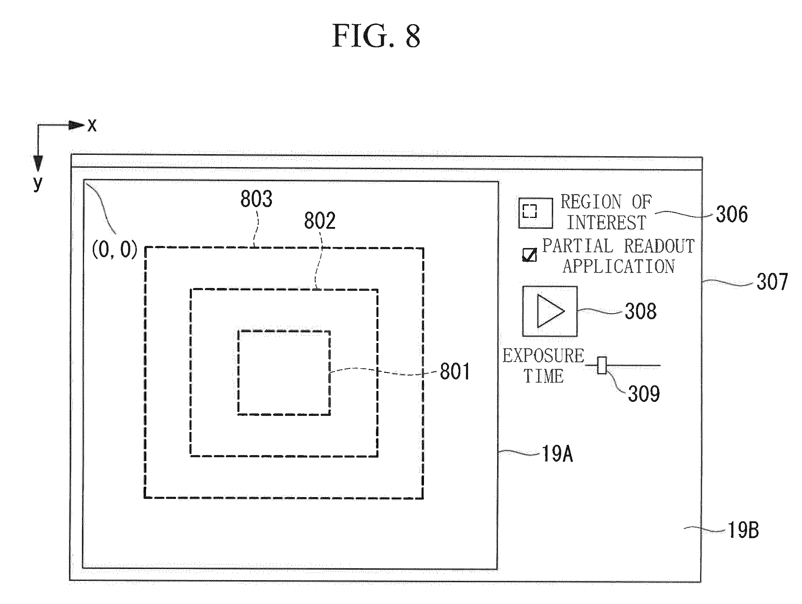

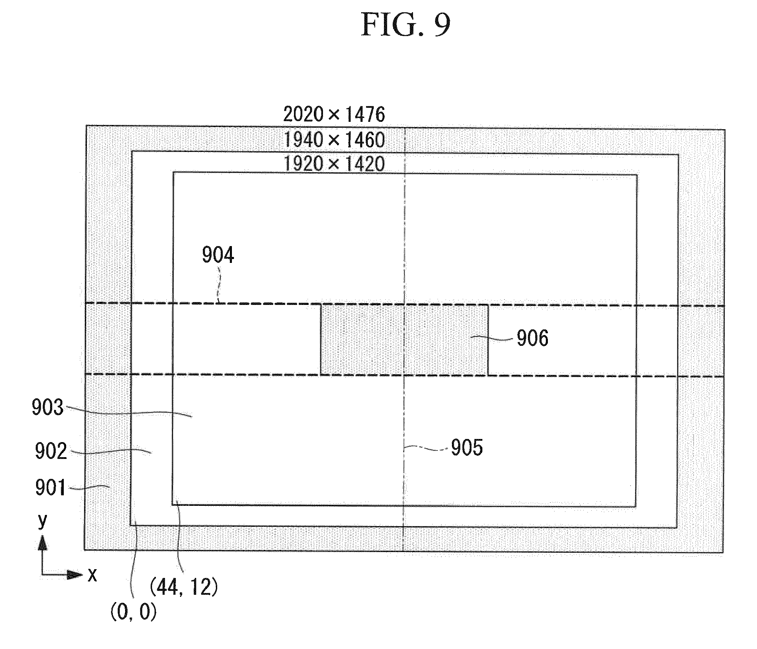

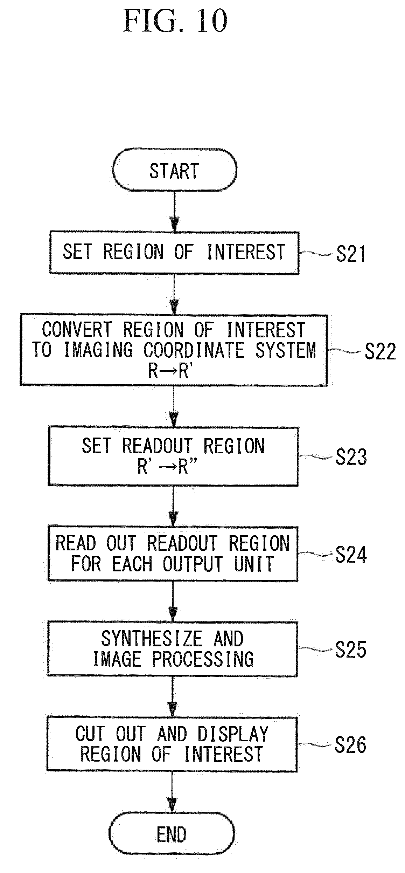

{Fig. 1} Fig. 1 is a block diagram illustrating a schematic configuration of an imaging apparatus according to a first embodiment of the present invention;
{Fig. 2} Fig. 2 is an explanatory diagram illustrating a structure of an imaging element in the imaging apparatus according to the first embodiment of the present invention; {Fig. 3}
Fig. 3 is an explanatory diagram illustrating an imaging coordinate system of the imaging element in the imaging apparatus according to the first embodiment of the present invention;
{Fig. 4} Fig. 4 is an explanatory diagram illustrating a display screen of a monitor in the imaging apparatus according to the first embodiment of the present invention;
{Fig. 5} Fig. 5 is a flowchart illustrating operation when a region of interest is partially read out in the imaging apparatus according to the first embodiment of the present invention;
{Fig. 6} Fig. 6 is an explanatory diagram illustrating a pattern of a drive signal for the imaging element in the first embodiment of the present invention;
{Fig. 7} Fig. 7 is an explanatory diagram illustrating a structure of an imaging element in an imaging apparatus according to a second embodiment of the present invention;
{Fig. 8} Fig. 8 is an explanatory diagram illustrating a display screen of a monitor in the imaging apparatus according to the second embodiment of the present invention;
{Fig. 9} Fig. 9 is an explanatory diagram illustrating an imaging coordinate system of the imaging element in the imaging apparatus according to the second embodiment of the present invention; and
{Fig. 10} Fig. 10 is a flowchart illustrating operation when a region of high interest is partially read out in the imaging apparatus according to the second embodiment of the present invention.

{Description of Embodiments}

{First Embodiment}

An imaging apparatus according to the first embodiment of the present invention will be described below with reference to the drawings.
As illustrated in Fig. 1, the imaging apparatus includes an imaging element 11 which acquires imaging signals which are images of a subject image, a drive circuit 12 which drives the imaging element 11, signal processing units 13 which perform predetermined signal processing on the imaging signals, a synthesizing unit 14 which generates a synthesized image, a memory 15 which temporarily stores signals to be processed in the synthesizing unit 14, an image processing unit 16 which performs predetermined image processing on the synthesized image synthesized by the synthesizing unit 14, a drive control unit 18 which controls the drive circuit 12, a monitor 19 which displays the image which has been subjected to image processing, and a control unit 17 which controls these units of the imaging apparatus.
As illustrated in Fig. 2, the imaging element 11 includes an effective pixel region 30 in which a plurality of unit regions including a plurality of pixels P for converting a subject image into imaging signals are adjacent to each other. In an example illustrated in Fig. 2, the effective pixel region 30 is comprised of two unit regions 31 and 32 which are disposed vertically and adjacent to each other. Further, in the unit regions 31 and 32, vertical transfer paths 35 and 36 and horizontal transfer paths 37 and 38 for transferring the imaging signals converted at photo diodes of the pixels P included in the unit regions 31 and 32, and output units 33 and 34 for outputting the imaging signals transferred from these transfer paths are respectively provided. That is, the imaging signals converted at the photo diodes of the pixels P included in the unit regions 31 and 32 can be output separately and simultaneously from the output units 33 and 34 to which the unit regions 31 and 32 belong.
Fig. 3 illustrates an imaging coordinate system of the imaging element 11. In the imaging coordinate system of Fig. 3, an optical black region 401 which is a pixel region defining a criterion for black in the imaging signals is disposed so as to encompass the effective pixel region 30, and has an origin (x, y) = (0, 0) at a lower left corner of the effective pixel region 30. The effective pixel region 30 which is a total region of pixels that can be output as imaging signals, is, for example, a region in which pixels of R, Gr, Gb and B are disposed. Among the effective pixel region 30, a non-display region 402 is disposed so as to encompass a display region 403. The display region 403 is a maximum region which can be displayed on a display region 19A of a monitor 19 which will be described later, and has an origin (x, y) = (44, 12) at a lower left corner of the display region 403. The imaging coordinate system of the display region 403 can be expressed with the following equation (1):

$$(x1, \ y1, \ w1, \ h1) \ = \ (44, \ 12, \ 1920, \ 1420) \qquad (1)$$

Further, an output unit boundary 404 which is a boundary between the output units 33 and 34, extends in a horizontal direction in Fig. 3, and divides the effective pixel region 30, and eventually, the imaging element 11 in a vertical direction (into an upper part and a lower part). In Fig. 3, a region of interest 406 is a region corresponding to a region of interest 305 in Fig. 4. In Fig. 3, a readout region 405 enclosed with a dashed line becomes a region to be actually read out from the imaging element 11 by a readout-region setting unit 26 (which will be described later) when the region of interest 305 is set.

The drive circuit 12 which is controlled by the drive control unit 18 (which will be described later), drives the imaging element 11 by supplying drive signals for reading out or sweeping out the imaging signals to the output units 33 and 34 of the imaging element 11.

The signal processing units 13 which are provided so as to correspond to the output units 33 and 34 in order to separately perform signal processing on the imaging signals output from the output units 33 and 34, each includes a pre-processing unit and an AD converting unit which are not illustrated. In each of the signal processing units 13, the pre-processing unit performs processing such as CDS, amplification, and OB clamp on outputs from the output units 33 and 34, then, the AD converting unit A/D converts the input signal from the pre-processing unit into a digital imaging signal.

The synthesizing unit 14 synthesizes input signals from the signal processing units 13 and synthesizes the imaging signals for each unit region which have been separately output from the output units 33 and 34 and which have been respectively subjected to predetermined processing, to generate a synthesized imaging signal as an image of the subject image.

The memory 15 temporarily stores the imaging signals to be synthesized in the synthesizing unit 14.

The image processing unit 16 performs predetermined image processing such as defect correction processing, white balance processing, black balance processing, demosaicing processing and edge emphasis processing on the digital synthesized imaging signal input from the synthesizing unit 14 and outputs the processed synthesized imaging signal to the control unit 17 which will be described later.

The control unit 17, for example, controls the imaging apparatus according to a program for controlling the imaging apparatus, executed at an external general purpose PC, or the like (not illustrated). Further, the control unit 17 includes a region-of-interest setting unit 25 and a readout-region setting unit 26, the region-of-interest setting unit 25 sets a region of interest for the subject image, and the readout-region setting unit 26 sets a region which includes the region of interest and which is axisymmetric with respect to a boundary (an output unit boundary 404) between the unit regions 31 and 32 among the effective pixel region 30 as a readout region 405.

That is, the control unit 17, for example, interprets a command obtained from an external general-purpose PC, or the like through a data bus to control each unit of the imaging apparatus. Specifically, the control unit 17 performs setting of a drive signal of the imaging element 11 for the drive control unit 18, setting of an exposure time of the imaging element 11 or readout or sweep-out of an electrical charge relating to the imaging signals, setting of image processing parameters, or the like. Further, when the readout region is set by the readout-region setting unit 26, the control unit 17 performs setting of readout of the electrical charge relating to the imaging signal in the set readout region, or the like for the drive control unit 18. The control unit 17 also displays the synthesized imaging signal received from the image processing unit 16 at a monitor 19 which will be described later as an image.

The drive control unit 18 controls the drive circuit 12 so as to drive the imaging element 11 according to a timing, a region, or the like for readout or sweep-out set by the control unit 17. When the readout region is set by the readout-region setting unit 26, the drive control unit 18 generates a drive signal for reading out the imaging signals of the pixels included in the readout region and sweeping out the imaging signals of the pixels other than the pixels included in the readout region and supplies this drive signal to the imaging element 11.

The monitor 19 not only displays the synthesized imaging signal received from the image processing unit 16 as an image, but also functions as a GUI, and, for example, a screen as illustrated in Fig. 4 is displayed at the monitor 19. As illustrated in Fig. 4, an image display region 19A for displaying an image and an operation button display region 19B are displayed at the monitor 19. In the image display region 19A, an image relating to the display region 403 except the non-display region 402 among the effective pixel region 30 of the imaging element 11 illustrated in Fig. 3 is displayed.

Further, in the operation button display region 19B, a region of interest display button 306, a partial readout application check box 307, a live start button 308 and an exposure time slider 309 are displayed. The region of interest display button 306 is a button for turning ON or OFF display of the region of interest 305, and the partial readout check box 307 is a check box for selecting whether or not to apply the partial readout. The live start button 308 is a button for starting or stopping live, and the exposure time slider 309 is a slider for changing or setting the exposure time.

Operation in a case where the region of interest is set and partially read out in the imaging apparatus configured as described above will be described below with reference to a flowchart of Fig. 5.

In response to a user pressing the live start button 308, a pre-image is acquired by the imaging element 11 and displayed at the monitor 19. Then, when the region of interest display button 306 is pressed, display of the region of interest is turned ON at the monitor 19, and, when the partial readout application check box 307 is checked, the partial readout processing of the region of interest is started.

In step S11, in this state, the region of interest is set by the region-of-interest setting unit 25 in response to an instruction from the user. The region of interest can be set by the region-of-interest setting unit 25, for example, by the user dragging a desired region to move the region to an arbitrary position within the display region and changing an outer periphery portion of the region to an arbitrary size within the display region.

Further, it is possible to set the region of interest by preparing region-of-interest candidates with a plurality of region sizes in advance, and the user selecting a desired region among these candidates as the region of interest. The set region of interest 305 is assumed to be R.

$$R = (X, Y, W, H) \qquad (2)$$

where X and Y are horizontal and vertical coordinates having their origins at an upper left corner of the image display region 19A, and W and H are respectively a width and a height (lengths in the horizontal direction and the vertical direction) of the region of interest.

In step S12, the region-of-interest setting unit 25 converts the region of interest R set on the monitor 19 into a region of interest R' in the imaging coordinate system.

$$R' = (X', Y', W', H') = (X+x1, Y+y1, W, H) \qquad (3)$$

where x1 and y1 are origins of the coordinate system in the display region 403 in the imaging coordinate system and as expressed in the above equation (1).

Subsequently, in step S13, a readout region R" which includes the region of interest R' and which is axisymmetric with respect to the boundary between the output units 33 and 34 is set by the readout-region setting unit 26. Here, as illustrated in Fig. 3, in the readout region 405, a first unit region 405a which includes the region of interest 406 and for which the shortest height (the shortest length in the vertical direction) is set and a second unit region 405b are axisymmetric with respect to the output unit boundary 404.

In this embodiment, partial readout is realized by high-speed sweep-out in the vertical direction. Therefore, all pixels are constantly read out in the horizontal direction, and the readout region which is axisymmetric with respect to the boundary between the output units 33 and 34 in the vertical direction is set.

{Equation 1}

$$H'' = \max(\text{abs}(1476/2) - Y'), \text{abs}((Y'+H') - 1476/2)) \times 2 \qquad \ldots(4)$$

$$R'' = (0, Y', 2020, H'') \qquad \ldots(5)$$

In step S14, the control unit 17 performs register setting for outputting a drive signal corresponding to the set readout region R", and sets the same drive signal for the drive control unit 18 and the signal processing units 13.

Fig. 6 illustrates a timing of the drive signal of the output unit 33 when the readout region is read out. Fig. 6 illustrates a vertical synchronization signal VD output by the drive control unit 18 and a horizontal synchronization signal HD output by the AD converting unit of the signal processing unit. SUB indicates an electrical charge extraction pulse output by the drive control unit 18, and the imaging element 11 accumulates an electrical charge as imaging signals while the SUB is not output. SG indicates a transfer pulse output by the drive control unit 18, and an electrical charge as the imaging signals accumulated in photo diodes of the imaging element 11 is transferred to a vertical transfer path.

When the electrical charge is transferred to the vertical transfer path, the drive control unit 18 drives a vertical drive signal V1-V4 at high speed to thereby sweep out pixels to be swept out at high speed. That is, the drive control unit 18 drives the imaging element 11 so as to sweep out imaging signals of the pixels other than the pixels in the readout region among the effective pixel region. Then, the drive control unit 18 vertically drives the vertical drive signal V1-V4 as usual to thereby read out imaging signals of the pixels included in the readout region R''.

In a similar manner, also in the output unit 34, the drive signal identical with that in the output unit 33 is output and the imaging signal is read out in a similar manner to the output unit 33. That is, the drive signal of the output unit 33 and the drive signal of the output unit 34 have substantially the same waveform, and substantially the same signal pattern.

In step S15, the read out imaging signals are respectively stored in the memory 15, and the synthesizing unit 14 respectively reads out the imaging signal of the output unit 33 and the imaging signal of the output unit 34 from the memory 15, synthesizes these imaging signals to generate a synthesized imaging signal and outputs the synthesized imaging signal. The synthesized imaging signal is subjected to predetermined processing by the image processing unit 16.

In step S16, the processed synthesized imaging signal is displayed on the monitor 19 as an image through the control unit 17. At this time, because the read out region is the readout region R'', the region of interest is cut out from the readout region R'' when the image is displayed, and the image relating to the region of interest is displayed in the display region 19A of the monitor 19.

As described above, according to this embodiment, when the region of interest is partially read out, because the imaging element 11 is driven to read out only the imaging signals of the pixels of the readout region 405 among the effective pixel region of the imaging element 11 without reading out the entire effective pixel region and sweep out the imaging signals of the pixels in other region, it is possible to increase a frame rate.

Further, because the readout region 405 is axisymmetric with respect to the boundary 404 between the unit regions 31 and 32, there is little difference between the imaging signals output from the output units 33 and 34 to which the unit regions belong. That is, because the imaging signals to be read out and the imaging signals to be swept out among the pixels included in the unit regions 31 and 32 have substantially the same signal pattern (both become the imaging signal as illustrated in Fig. 6), the amounts of heat generation at the output units become substantially the same. It is therefore possible to perform partial readout while suppressing a difference between the imaging signals which are output signals at the output units, so that it is possible to output high-quality images at high frame rate.

It should be noted that, in the above-described example, there is only one region of interest and the region of interest is included in a single output unit, this example does not limit the disposition of the region of interest. It is only necessary to set a region which is axisymmetric with respect to a boundary of a plurality of output units as a readout region and read out this region, and it is, for example, possible to set a plurality of regions of interest, or it is also possible to set a region of interest across a plurality of output units when there are three or more output units.

{Second Embodiment}

The second embodiment of the present invention will be described below.

An imaging apparatus according to this embodiment differs from the imaging apparatus according to the first embodiment in an imaging element and in drive control of the imaging apparatus in association with the difference in the imaging element.

Further, this embodiment employs a configuration in which partial readout is performed by selecting a desired region of interest among a plurality of region-of-interest candidates set in advance instead of setting an arbitrary region when the region of interest is set.

In the following description, the same reference numerals will be assigned to components identical with those of the imaging apparatus according to the first embodiment, and the explanation thereof will be omitted.

As illustrated in Fig. 7, the imaging element 11 includes an effective pixel region 30 in which a plurality of unit regions including a plurality of pixels P for converting a subject image into imaging signals are adjacent to each other. In this embodiment, the effective pixel region 30 of the imaging element 11 is comprised of two unit regions 31 and 32 which are disposed horizontally and adjacent to each other.

As illustrated in Fig. 8, in the display region 19A of the monitor 19, the following region-of-interest candidates are displayed:

a region-of-interest candidate 801 (X, Y, W, H) = (840, 633, 240, 153),
a region-of-interest candidate 802 (X, Y, W, H) = (480, 557, 480, 305), and
a region-of-interest candidate 803 (X, Y, W, H) = (240, 305, 960, 710).

These region-of-interest candidates are all partial regions included in the display region 805 and are regions set so as to be axisymmetric with respect to the boundary between the output units 33 and 34.

In the image display region 19A of the monitor 19, a display region 903 except an optical black region 901 and a non-display region 902 of the effective pixel region 30 in the imaging coordinate system of the imaging element 11 illustrated in Fig. 9 is displayed.

Here, the display region 903 in Fig. 9 is a maximum region which can be displayed on the image display region 19A of the monitor 19, and there is an origin (x, y) = (44, 12) of the display region 903 at the lower left corner of the display region 903. The imaging coordinate system of the display region 903 is expressed with the following equation (6):

$$(x2, y2, w2, h2) = (44, 12, 1920, 1420) \qquad (6)$$

It should be noted that, as illustrated in Fig. 9, the optical black region 901 is a region disposed so as to encompass the non-display region 902 and has an origin (x, y) = (0, 0) at the lower left corner. The effective pixel region 30 is a region in which pixels of R, Gr, Gb and B are disposed. The output unit boundary 905 which is a boundary between the pixels to be read out from the output unit 33 of the imaging element 11 and the pixels to be read out from the output unit 34, extends in a vertical direction and divides the effective pixel region 30 of the imaging element 11 in a horizontal direction (into a left part and a right part). In Fig. 9, the region of interest 906 is a region corresponding to any of the regions of interest in Fig. 8. In Fig. 9, the readout region 904 expressed with a dashed line becomes a region to be actually read out from the imaging element 11 by the readout-region setting unit 26 when the region of interest is set on the monitor 19 in Fig. 8.

In the operation button display region 19B of the monitor 19, a region of interest display button 306, a partial readout application check box 307, a live start button 308 and an exposure time slider 309 are displayed in a similar manner to the monitor of the imaging apparatus according to the first embodiment.

Operation in a case where the region of interest is set and partially read out in the imaging apparatus as configured above will be described below with reference to the flowchart of Fig. 10.

In response to the user pressing the live start button 308, a pre-image is acquired by the imaging element 11 and displayed at the monitor 19. Then, when the region of interest display button 306 is pressed, display of the region of interest on the monitor 19 is turned ON, and when the partial readout application check box 307 is checked, processing of partially reading out the region of interest is started.

In step S21, in this state, the region of interest is set by the region-of-interest setting unit 25 in response to an instruction from the user.

The region-of-interest setting unit 25 turns ON display of the region of interest in response to the region of interest display button 306 being pressed, and displays a plurality of region-of-interest candidates. That is, for example, the region-of-interest candidate 801, the region-of-interest candidate 802 and the region-of-interest candidate 803 are sequentially displayed while the user drags an outer periphery portion of the region of interest, so that the user is allowed to select any of these candidates, and the user selects and sets any one candidate as a region of interest R.

$$R = (X, Y, W, H)$$

where X and Y are horizontal and vertical coordinates having their origins at an upper left corner of the image display region 19A, and W and H are respectively a width and a height of the region of interest.

In step S22, the region-of-interest setting unit 25 converts the region of interest R set on the monitor 19 into a region of interest R' in the imaging coordinate system.

$$R' = (X', Y', W', H') = (X+x2, Y+y2, W, H)$$

where x2 and y2 are origins of the coordinate of the display region R in the imaging coordinate system and as expressed in the above equation (6).

Subsequently, in step S23, the readout-region setting unit 26 sets a readout region R" which includes the region of interest R' and which is axisymmetric with respect to the boundary between the output units 33 and 34. That is, in this embodiment, because the region of interest R' is axisymmetric with respect to the boundary between the output units 33 and 34, the readout region R" is set by expanding the region of interest R' in the horizontal direction so as to realize high speed and simple readout.

Because the imaging element 11 of this embodiment includes two unit regions 31 and 32 which are horizontally disposed and adjacent to each other, partial readout is realized by performing high-speed sweep-out in the vertical direction and constantly reading out all the pixels in the horizontal direction. Therefore, a region which is axisymmetric with respect to the boundary between the output units 33 and 34 in the vertical direction is set as the readout region R''.

$$R'' = (X'', Y'', W'', H'') = (0, Y', 2020, H')$$

The control unit 17 performs register setting for outputting a drive signal corresponding to the set readout region R" and sets the same drive signal for the drive control unit 18 and the signal processing units 13.

In the subsequent steps S24 to S26, in a similar manner to the above-described first embodiment, the read out imaging signals are respectively stored in the memory 15, and the synthesizing unit 14 respectively reads out the imaging signal of the output unit 33 and the imaging signal of the output unit 34 from the memory 15, synthesizes these imaging signals to generate a synthesized imaging signal and outputs the synthesized imaging signal. The synthesized imaging signal is subjected to predetermined processing by the image processing unit 16.

The processed synthesized imaging signal is displayed on the monitor 19 as an image through the control unit 17. At this time, because the read out region is the readout region R'', the region of interest is cut out from the readout region R" when the image is displayed, and the image relating to the region of interest is displayed in the display region 19A of the monitor 19.

As described above, according to this embodiment, because a plurality of region-of-interest candidates are held in advance, the user can set the region of interest only through simple operation of selecting any one of the region-of-interest candidates which includes a desired region. Further, because the region of interest itself is axisymmetric with respect to the boundary between the unit regions, it is possible to set the set region of interest as is or set the region of interest after extending the region in a direction in which the region of interest is axisymmetric as a readout region, so that it is possible to output high-quality images at high frame rate. by performing partial readout while suppressing a difference between the imaging signals which are output signals at the output units, while reducing the amount of operation.

It should be noted that while a configuration has been described in the above-described embodiments where the effective pixel region has two unit regions, the present invention is not limited to this configuration, and it is also possible to employ a configuration where three or more unit regions and output units corresponding to the unit regions are provided.

{Reference Signs List}

| | |
|---|---|
| 11 | Imaging element |
| 12 | Drive circuit |
| 13 | Signal processing unit |
| 14 | Synthesizing unit |
| 15 | Memory |
| 16 | Image processing unit |
| 17 | Control unit |
| 18 | Drive control unit |
| 19 | Monitor |
| 19A | Image display region |
| 19B | Operation button display region |
| 25 | Region-of-interest setting unit |
| 26 | Readout-region setting unit |

**Claims**

1.  An imaging apparatus comprising:

    an imaging element including an effective pixel region in which a plurality of unit regions are adjacent to one another, the unit regions each including a plurality of pixels for converting a subject image into imaging signals;

and a plurality of output units provided for the respective unit regions, the output units outputting the imaging signals obtained by conversion at the pixels included in the respective unit regions;
a region-of-interest setting unit that sets a region of interest for the subject image;
a readout-region setting unit that sets a region including the region of interest and axisymmetric with respect to a boundary between the unit regions as a readout region in the effective pixel region; and
a drive control unit that drives the imaging element to read out imaging signals of the pixels included in the readout region, and to sweep out imaging signals of the pixels other than the pixels included in the readout region.

2. The imaging apparatus according to claim 1, wherein the unit regions are obtained by dividing the effective pixel region in a horizontal direction, and the output units are provided for the respective unit regions.

3. The imaging apparatus according to claim 1, wherein the unit regions are obtained by dividing the effective pixel region in a vertical direction, and the output units are provided for the respective unit regions.

4. The imaging apparatus according to any one of claims 1 to 3, wherein the region-of-interest setting unit holds in advance a plurality of regions axisymmetric with respect to the boundary between the unit regions as region-of-interest candidates, and sets any one of the region-of-interest candidates as the region of interest.

# FIG. 1

# FIG. 2

# FIG. 3

EP 2 869 552 A1

# FIG. 4

EP 2 869 552 A1

# FIG. 5

```
          ┌─────────────┐
          │    START    │
          └──────┬──────┘
                 │
                 ▼
      ┌───────────────────────┐
      │ SET REGION OF INTEREST │──── S11
      └───────────┬───────────┘
                  │
                  ▼
   ┌──────────────────────────────┐
   │ CONVERT REGION OF INTEREST    │
   │ TO IMAGING COORDINATE SYSTEM  │──── S12
   │            R→R'               │
   └───────────────┬──────────────┘
                   │
                   ▼
      ┌───────────────────────┐
      │   SET READOUT REGION   │──── S13
      │        R'→R"          │
      └───────────┬───────────┘
                  │
                  ▼
      ┌───────────────────────┐
      │ READ OUT READOUT REGION │──── S14
      │ FOR EACH OUTPUT UNIT    │
      └───────────┬───────────┘
                  │
                  ▼
      ┌───────────────────────┐
      │     SYNTHESIZE AND      │──── S15
      │   IMAGE PROCESSING      │
      └───────────┬───────────┘
                  │
                  ▼
      ┌───────────────────────┐
      │  CUT OUT AND DISPLAY    │──── S16
      │  REGION OF INTEREST     │
      └───────────┬───────────┘
                  │
                  ▼
          ┌─────────────┐
          │     END     │
          └─────────────┘
```

# FIG. 6

VD

HD

SUB

ACCUMULATION

SG

V1-V4

READOUT AT OUTPUT UNIT 33

CYCLE A

vout1-A

vout1-B

HIGH-SPEED SWEEP-OUT

USUAL READOUT

# FIG. 7

# FIG. 8

REGION OF INTEREST — 306

PARTIAL READOUT APPLICATION — 307

308

EXPOSURE TIME — 309

19A

19B

EP 2 869 552 A1

FIG. 9

# FIG. 10

```
                    ┌──────────┐
                    │  START   │
                    └────┬─────┘
                         │
                         ▼
        ┌────────────────────────────────┐
        │    SET REGION OF INTEREST       │───── S21
        └────────────────┬───────────────┘
                         │
                         ▼
        ┌────────────────────────────────┐
        │   CONVERT REGION OF INTEREST    │
        │ TO IMAGING COORDINATE SYSTEM    │───── S22
        │            R→R'                 │
        └────────────────┬───────────────┘
                         │
                         ▼
        ┌────────────────────────────────┐
        │       SET READOUT REGION        │
        │            R' →R"               │───── S23
        └────────────────┬───────────────┘
                         │
                         ▼
        ┌────────────────────────────────┐
        │    READ OUT READOUT REGION      │
        │     FOR EACH OUTPUT UNIT        │───── S24
        └────────────────┬───────────────┘
                         │
                         ▼
        ┌────────────────────────────────┐
        │        SYNTHESIZE AND           │
        │      IMAGE PROCESSING           │───── S25
        └────────────────┬───────────────┘
                         │
                         ▼
        ┌────────────────────────────────┐
        │     CUT OUT AND DISPLAY         │
        │     REGION OF INTEREST          │───── S26
        └────────────────┬───────────────┘
                         │
                         ▼
                    ┌──────────┐
                    │   END    │
                    └──────────┘
```

20

Europäisches
Patentamt

European
Patent Office

Office européen
des brevets

# EUROPEAN SEARCH REPORT

**Application Number**

EP 14 18 8115

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2007/229689 A1 (YAMADA TETSUO [JP]) 4 October 2007 (2007-10-04) | 1-3 | INV. H04N5/345 H04N5/372 |
| Y | * the whole document * | 1-4 | |
| X | US 2006/055802 A1 (PARKS CHRISTOPHER [US]) 16 March 2006 (2006-03-16) | 1,2 | |
| Y | * the whole document * | 1-4 | |
| Y | US 2003/193591 A1 (MIYAHARA HIROYUKI [JP]) 16 October 2003 (2003-10-16) * the whole document * | 1-4 | |
| Y | US 2007/216791 A1 (OSHIMA HIROYUKI [JP]) 20 September 2007 (2007-09-20) * figures 2,6 * * paragraph [0039] - paragraph [0045] * * paragraph [0080] - paragraph [0089] * | 2,3 | |
| Y | US 2010/309305 A1 (NAKATSUKA MASAYUKI [JP] ET AL) 9 December 2010 (2010-12-09) * figures 4, 9 * * paragraph [0082] - paragraph [0096] * * paragraph [0140] - paragraph [0142] * | 4 | TECHNICAL FIELDS SEARCHED (IPC) H04N |
| Y | US 4 910 599 A (HASHIMOTO SEIJI [JP]) 20 March 1990 (1990-03-20) * column 14, line 63 - column 15, line 2 * | 4 | |
| Y | JP H07 67032 A (CANON KK) 10 March 1995 (1995-03-10) * abstract * * figure 5 * * paragraph [0047] - paragraph [0053] * | 4 | |
| Y | US 2002/154912 A1 (KOSEKI HIROAKI [JP] ET AL) 24 October 2002 (2002-10-24) * figure 10 * * paragraphs [0097], [0098] * | 4 | |

The present search report has been drawn up for all claims

| Place of search | Date of completion of the search | Examiner |
|---|---|---|
| Munich | 2 March 2015 | Moorhouse, David |

EPO FORM 1503 03.82 (P04C01)

## ANNEX TO THE EUROPEAN SEARCH REPORT
## ON EUROPEAN PATENT APPLICATION NO.

EP 14 18 8115

This annex lists the patent family members relating to the patent documents cited in the above-mentioned European search report.
The members are as contained in the European Patent Office EDP file on
The European Patent Office is in no way liable for these particulars which are merely given for the purpose of information.

02-03-2015

| Patent document cited in search report | | Publication date | Patent family member(s) | | Publication date |
|---|---|---|---|---|---|
| US 2007229689 | A1 | 04-10-2007 | EP | 1841202 A2 | 03-10-2007 |
| | | | JP | 4740781 B2 | 03-08-2011 |
| | | | JP | 2007267333 A | 11-10-2007 |
| | | | US | 2007229689 A1 | 04-10-2007 |
| US 2006055802 | A1 | 16-03-2006 | US | 2006055802 A1 | 16-03-2006 |
| | | | US | 2009180018 A1 | 16-07-2009 |
| US 2003193591 | A1 | 16-10-2003 | EP | 1353383 A2 | 15-10-2003 |
| | | | JP | 3879987 B2 | 14-02-2007 |
| | | | JP | 2003304452 A | 24-10-2003 |
| | | | US | 2003193591 A1 | 16-10-2003 |
| US 2007216791 | A1 | 20-09-2007 | JP | 4773234 B2 | 14-09-2011 |
| | | | JP | 2007251352 A | 27-09-2007 |
| | | | US | 2007216791 A1 | 20-09-2007 |
| US 2010309305 | A1 | 09-12-2010 | AT | 515881 T | 15-07-2011 |
| | | | EP | 2262225 A1 | 15-12-2010 |
| | | | JP | 5336936 B2 | 06-11-2013 |
| | | | JP | 2010283724 A | 16-12-2010 |
| | | | US | 2010309305 A1 | 09-12-2010 |
| US 4910599 | A | 20-03-1990 | DE | 3887547 D1 | 17-03-1994 |
| | | | DE | 3887547 T2 | 25-08-1994 |
| | | | EP | 0282993 A2 | 21-09-1988 |
| | | | US | 4910599 A | 20-03-1990 |
| JP H0767032 | A | 10-03-1995 | JP | 3406924 B2 | 19-05-2003 |
| | | | JP | H0767032 A | 10-03-1995 |
| US 2002154912 | A1 | 24-10-2002 | EP | 1250001 A2 | 16-10-2002 |
| | | | EP | 1641247 A2 | 29-03-2006 |
| | | | JP | 2002314868 A | 25-10-2002 |
| | | | US | 2002154912 A1 | 24-10-2002 |

EPO FORM P0459

For more details about this annex : see Official Journal of the European Patent Office, No. 12/82

**EP 2 869 552 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2004146897 A
- JP 2004104561 A